# FASCICULE DE BREVET EUROPEEN

(11) **EP 1 137 190 B1**
(45) Date de publication et mention de la délivrance du brevet: **26.04.2006**
(21) Numéro de dépôt: 01400503.7
(22) Date de dépôt: 27.02.2001
(51) Int. Cl.: H03M 3/04

(54) **Système de correction du CNA pour modulateur delta-sigma**
DAW-Korrektionssystem für einen Delta-Sigma Modulator
DAC correction system for a delta-sigma modulator

(30) Priorité: 01.03.2000 FR 0002611
(43) Date de publication de la demande: 26.09.2001
(73) Titulaire: STMicroelectronics S.A., 92120 Montrouge (FR)
(72) Inventeur: Andre, Eric, 38180 Seyssins (FR); Paillardet, Frédéric, 73100 Aix-les-Bains (FR)
(74) Mandataire: Texier, Christian

(56) Documents cités:
- EP-A- 0 964 524
- GROENEVELD D W J ET AL: "A SELF-CALIBRATION TECHNIQUE FOR MONOLITHIC HIGH-RESOLUTION D/A CONVERTERS" IEEE JOURNAL OF SOLID-STATE CIRCUITS,US,IEEE INC. NEW YORK, vol. 24, no. 6, 1 décembre 1989 (1989-12-01), pages 1517-1522, XP000100482 ISSN: 0018-9200
- BAIRD R T ET AL: "A LOW OVERSAMPLING RATIO 14-B 500-KHZ DELTASIGMA ADC WITH A SELF-CALIBRATED MULTIBIT DAC" IEEE JOURNAL OF SOLID-STATE CIRCUITS,IEEE INC. NEW YORK,US, vol. 31, no. 3, 1 mars 1996 (1996-03-01), pages 312-320, XP000597403 ISSN: 0018-9200

## Description

La présente invention concerne la modulation ΔΣ, et plus précisément la prise en compte et la correction d'imperfections d'un convertisseur interne N/A, de modulateur ΔΣ.

Les modulateurs ΔΣ réalisent une conversion analogique-numérique ou numérique-analogique avec un grand nombre de bits de résolution au moyen de convertisseurs internes Analogique/Numérique (CAN) ou Numérique/Analogique (CNA) de faible résolution, typiquement de 1 à 4 bits.

Ceci est rendu possible notamment grâce à un suréchantillonnage du signal analogique et à une mise en forme de bruit de quantification.

Les modulateurs ΔΣ comprennent généralement, par exemple sur une branche de contre-réaction, un CNA qui est généralement « 1 bit ».

Un tel CNA « 1 bit » ne possède que 2 niveaux en sortie (+Vréf et -Vréf) pouvant être reliés par une droite (il est intrinsèquement linéaire).

A chaque comparaison du signal à son entrée avec une tension de référence Vréf, ce CNA quantificateur associe au niveau d'entrée une tension +Vref ou une tension -Vref.

On a proposé de remplacer le CNA « 1 bit » par un CNA multibit, mais les modulateurs ΔΣ multibit s'avèrent limités en performance par un manque de précision du CNA interne.

En effet, au-delà de 1 bit, la disparité entre les niveaux de sortie va se traduire par une non-linéarité du CNA, c'est-à-dire par des défauts de proportionnalité entre l'entrée et la sortie du CNA, limitant ainsi les performances du CNA. Cette disparité est due à l'imprécision sur les composants unitaires utilisés, par exemple sur les valeurs des différentes capacités dans le cas d'un modulateur ΔΣ à capacités commutées intégré sur silicium.

Par exemple, si l'on désire obtenir un convertisseur analogique-numérique de 16 bits avec un modulateur ΔΣ multibit, cela signifie que la linéarité de son CNA interne devra être d'au moins 16 bits.

Atteindre des performances acceptables pour un CNA multibit suppose des techniques de réalisation complexes et coûteuses (ajustage au laser, appariement des composants) ce qui détruit l'intérêt de la modulation ΔΣ qui est initialement d'obtenir des performances élevées avec des composants peu complexes, notamment afin de pouvoir être facilement intégrés sur silicium.

On a proposé des systèmes et des algorithmes de correction des imperfections des composants des convertisseurs N/A, ainsi que des systèmes d'autocalibration de ces composants. Ils n'ont toutefois permis d'obtenir que des systèmes limités en vitesse de fonctionnement et en résolution.

Ainsi, dans le document [1], on a proposé un convertisseur numérique/analogique à plusieurs sources de courant fournissant chacune ou bien une intensité constante de valeur précisément fixée, ou bien une intensité nulle, la valeur numérique d'entrée déterminant le nombre de sources activées.

Ce document propose d'adopter une source supplémentaire en plus du nombre de sources nécessaires à la conversion.

Ainsi, les sources sont chacune successivement extraites du processus de conversion pour être étalonnées sur une valeur d'intensité préfixée. Il y a donc en permanence un nombre de sources suffisant en activité, et une source en cours d'étalonnage.

Le procédé décrit dans ce document présente l'inconvénient d'avoir une durée nécessaire à la calibration qui dépend de la technologie. Du fait de l'utilisation de composants unitaire limitée aux sources de courant, la consommation et la surface d'intégation sur silicium restent relativement élevées.

Dans le cas d'un convertisseur numérique/analogique interne de modulateur ΔΣ, on a proposé dans le document [2] un procédé de correction des erreurs sur les paramètres de conversion consistant à appliquer des vecteurs de correction dans le domaine numérique.

Selon ce procédé, on mesure les défauts liés aux inexactitudes sur les éléments du convertisseur numérique/analogique, lors d'une phase de calibrage nécessitant l'arrêt du convertisseur.

Les erreurs sont mesurées pour chacune des combinaisons d'états de chargement des capacités, soit pour 16 combinaisons possibles. On applique ensuite le vecteur d'erreur ainsi déterminé, dans le domaine numérique.

Du fait qu'il nécessite un arrêt de la conversion pour la détermination du vecteur d'erreur, ce procédé est difficilement adaptable dans les convertisseurs devant fonctionner en continu. Du fait qu'il ne fournit pas une adaptation continue du vecteur d'erreur, il est particulièrement sensible aux modifications des valeurs des paramètres en cours de conversion que l'on rencontre dans ce type de convertisseurs.

Dans le document EP-A-0964524, on a proposé une correction de filtre non-linéaire des modulateurs ΣΔ multibits.

L'invention vise à proposer un modulateur ΔΣ N/A ou A/N multibit, apte à prendre en compte en cours de conversion des erreurs de paramètre de fonctionnement des composants unitaires du convertisseur numérique-analogique interne, et à corriger automatiquement ces erreurs.

Ce but est atteint selon l'invention grâce à un convertisseur ΔΣ comprenant des moyens pour mesurer une erreur due à des écarts de paramètres de fonctionnement de composants unitaires de son convertisseur interne N/A, et des moyens pour appliquer une correction de l'erreur ainsi mesurée sur un signal numérique, caractérisé en ce que le convertisseur interne comprend un nombre de composants unitaires supérieur à celui nécessaire à la conversion interne, et que les moyens de mesure sont aptes à extraire alternativement du processus de conversion interne un composant à chaque fois différent parmi les différents composants unitaires, tout en laissant actifs un nombre de composants suffisant à la conversion interne, afin de mesurer l'erreur de paramètre de fonctionnement de ce composant extrait.

D'autres caractéristiques, buts et avantages de l'invention apparaîtront à la lecture de la description détaillée qui va suivre, faite en référence aux figures annexées sur lesquelles :
- la figure 1 représente un assemblage modulateur A/N de l'état de la technique ;
- la figure 2 représente de manière schématique une série de composants de quantification montés en parallèle ;
- la figure 3 représente une caractéristique de convertisseur numérique/analogique interne à N+1 niveaux de sortie ;
- la figure 4 représente un montage d'une capacité unitaire pour la conversion N/A, selon l'invention ;
- la figure 5 représente un modulateur ΔΣ A/N selon l'invention ;

Le modulateur ΔΣ de la figure 5 se compose
- d'une branche principale B1 qui porte de façon classique un filtre analogique 10 suivi d'un convertisseur A/N 20, et ;
- d'une branche de contre-réaction B₂ qui porte un CNA 50. La branche de contre-réaction B2 relie la sortie 30 de la branche principale B1 à l'entrée 40 de cette même branche principale, où les deux branches B1 et B2 se rejoignent par un sommateur 42.

Le CNA 50 est ici un CNA multibit à capacités commutées intégrées sur silicium.

Le modulateur présente en outre une unité de correction 60 reliée au CNA 50 par une liaison 61 pour prélever sur celui-ci une mesure d'écarts de paramètres de chaque élément de quantification de ce CNA 50.

L'unité de correction 60 présente également une liaison de commande représentée par une double flèche 62 par laquelle elle commande une commutation des différentes capacités du CNA 50 en vue de les extraire l'une après l'autre du processus de conversion.

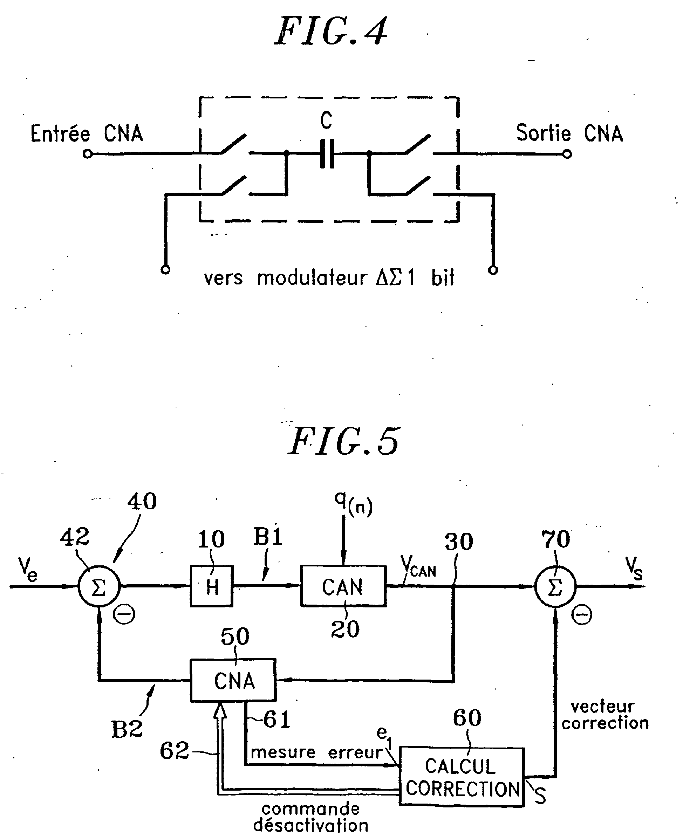

Pour cela, les capacités du CNA 50 sont montées conformément à la figure 4, chacune entre deux commutateurs aptes chacun à relier la capacité ou bien au reste du CNA, ou bien à la liaison de mesure 61 par laquelle l'unité 60 mesure alors la valeur de cette capacité.

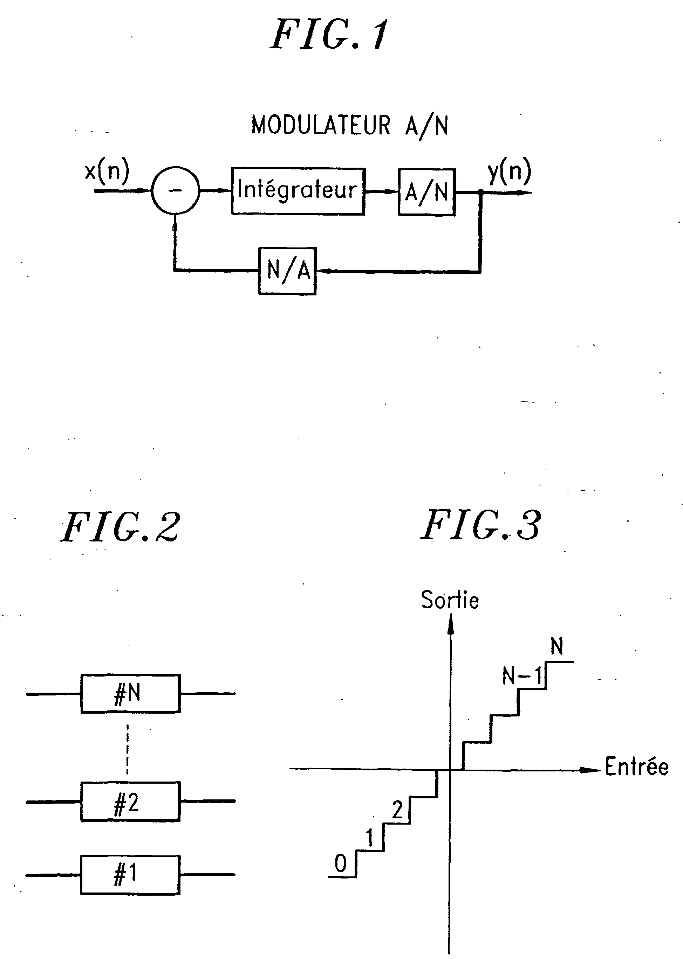

Le convertisseur interne est préférentiellement composé d'éléments unitaires, c'est-à-dire d'éléments de quantification ayant même valeur. Par exemple, un CNA avec 9 niveaux de sortie sera composé de N=8 capacités unitaires afin de former les codes 0, 1, .. . ,8, conformément aux figures 2 et 3.

En cours de conversion, on extrait constamment une capacité du processus de conversion.

L'unité 60 déduit à partir de la mesure de cette capacité un éventuel écart de la valeur de la capacité par rapport à la valeur attendue, et met à jour un vecteur d'erreur à partir duquel elle génère un vecteur de correction qui sera appliqué au modulateur ΔΣ, dans le domaine numérique.

La correction s'effectue alors en réinjectant le vecteur de correction en sortie du modulateur ΔΣ, A/N.

Afin d'effectuer les opérations de mesure des capacités sans perturber le fonctionnement du modulateur ΔΣ, le CNA 50 comporte un élément unitaire (capacité) supplémentaire afin que celui extrait puisse être remplacé par celui précédemment extrait.

Ainsi, le présent CNA ayant 9 niveaux de sortie, alors qu'il devrait comporter comme à l'habitude 8 capacités, il comporte ici 8 + 1 = 9 capacités unitaires.

Comme mentionné précédemment, le remplacement d'une capacité unitaire par une autre est effectué au moyen d'une gestion appropriée des interrupteurs commutant les capacités, sous la commande de l'unité 60.

Au bilan, le fonctionnement du modulateur ΔΣ n'est pas perturbé grâce à l'utilisation d'un élément unitaire supplémentaire par rapport à un nombre N d'éléments unitaires nécessaires à la conversion.

Un élément unitaire parmi les N+1 pourra se substituer à celui en cours de calibration de manière à ce que le CNA voit toujours les N éléments unitaires nécessaires.

Ainsi, pour chaque capacité extraite, l'unité 60 mesure la valeur de la capacité et calcule à partir de l'écart de cette capacité par rapport à la valeur idéale qui en est attendue, la correction à apporter au signal numérique de sortie du modulateur ΔΣ A/N.

Plus précisément, l'unité 60 détermine à partir de chaque nouvelle mesure de capacité une série de valeurs des erreurs actualisées sous forme d'un vecteur, et le sommateur 70 ajoute aux valeurs de sortie V_{CAN} du modulateur ΔΣ, une combinaison de ces différentes valeurs du vecteur d'erreur.

Le sommateur 70 est pour cela un sommateur adapté à ajouter aux données de sortie V_{CAN} une valeur de correction qui correspond spécifiquement à l'amplitude de la valeur de sortie instantanée V_{CAN} du CAN 30.

L'unité 60 remplit donc à la fois une fonction de commande de l'extraction d'une des capacités du CNA 50, une fonction de mesure de la valeur de cette capacité, et une fonction de calcul de mise à jour du vecteur correction à transmettre au sommateur 70.

Pour la mesure de la capacité extraite et selon un mode de réalisation préférentiel de l'invention, l'unité 60 comprend elle même un modulateur ΔΣ 1 bit d'ordre 1 analogique/numérique dont la structure générale, non représentée sur la figure 5, est conforme à celle de la figure 1.

Le système proposé extrait donc la valeur exacte de chaque élément unitaire (capacité) en l'incluant dans un modulateur ΔΣ 1 bit d'ordre 1.

La capacité unitaire mesurée joue le rôle de capacité d'échantillonnage du modulateur ΔΣ 1 bit d'ordre 1, ce modulateur ΔΣ 1 bit d'ordre 1 étant soumis à un signal d'entrée qui est égal à la tension de référence de ce modulateur ΔΣ 1 bit d'ordre 1.

Ce modulateur supplémentaire est préférentiellement suivi d'un moyenneur composé, comme exposé dans le document [2], de deux compteurs n bits, et dont le rôle est de calculer une moyenne des différentes valeurs de sortie du modulateur supplémentaire.

Selon la valeur de la capacité mesurée, on obtient en sortie du CAN 1 bit une occurrence de valeurs + Vréf plus ou moins forte par rapport aux occurrences des valeurs -Vréf, cette différence d'occurrence étant proportionnelle à la valeur effective de la capacité.

Le moyenneur délivre donc une valeur proportionnelle à la différence entre les fréquences d'apparition des valeurs +Vréf et -Vréf, c'est à dire proportionnelle à la valeur de capacité effective.

La valeur délivrée par le moyenneur est une valeur numérique, de sorte que l'ensemble 60 réalise également une fonction de conversion analogique-numérique qui permet d'écrire la valeur de chaque capacité dans une mémoire de l'unité 60.

L'utilisation d'un modulateur ΔΣ 1 bit d'ordre 1 pour numériser la valeur exacte de la capacité unitaire permet d'obtenir une résolution élevée (16 bits) avec une complexité réduite.

Pour -obtenir une précision de 16 bits sur la mesure d'un élément unitaire, il faut au moins 216 (=65536) échantillons.

En considérant un modulateur ΔΣ d'ordre 1 travaillant à 40 Mhz, cela signifie que chaque élément unitaire sera calibré en 1,64 ms.

Le temps nécessaire pour auto-calibrer le CNA interne est donc suffisamment bref pour considérer le système proposé comme robuste vis-à-vis des perturbations extérieures (variations de température, vieillissement,...).

En d'autres termes, le système modifie la correction effectuée avec une rapidité plus élevée que la vitesse de variation des valeurs des capacités.

Le temps de calibration est suffisamment court (quelques millisecondes) pour considérer que l'effet des variations des valeurs de chaque élément unitaire (écarts de températures, vieillissement des composants,...) n'a pas le temps de se manifester entre deux mesures et mises à jour correspondantes.

Le surplus de complexité apporté par l'autocalibration est rendu très faible grâce à l'utilisation d'un modulateur ΔΣ 1 bit d'ordre 1.

En mesurant la valeur exacte d'un élément unitaire par le modulateur ΔΣ 1 bit d'ordre 1, ce dernier peut introduire un gain de conversion non souhaité. Ce gain est toutefois identique à chaque élément unitaire mesuré, donc il n'a que peu d'influence sur les performances du système proposé.

On a ainsi pu remarquer qu'une variation de 3% dégradera le rapport signal à bruit d'environ 1 dB par rapport au cas idéal.

L'invention s'applique également aux modulateurs ΔΣ destinés à la Conversion Numérique-Analogique.

De tels modulateurs ΔΣ présentent là encore un CNA interne, dont les éléments unitaires, (par exemple capacités ou résistances) présentent des variations non souhaitées de leurs paramètres.

Un tel CNA interne est typiquement placé sur une branche principale, en sortie du modulateur ΔΣ.

Dans un mode de réalisation préféré de l'invention, on munit le CNA d'un élément unitaire supplémentaire et on prévoit une unité semblable à l'unité 60 précédemment décrite, qui extrait tour à tour chacun des composants unitaires du CNA, mesure le paramètre du composant extrait et calcule à partir de cette mesure un vecteur d'erreur actualisé.

Ce vecteur d'erreur est ensuite soustrait aux valeurs numériques arrivant en entrée du modulateur ΔΣ numérique-analogique.

L'unité de correction est donc préférentiellement placée dans une boucle de contre-réaction du modulateur ΔΣ N/A.

Préférentiellement, l'unité de correction inclut un modulateur 1 bit d'ordre 1, et elle utilise l'élément unitaire extrait en tant que capacité d'échantillonage de ce modulateur 1 bit d'ordre 1.

Le système permet la réalisation de convertisseurs ΔΣ multibit (analogique-numérique et numérique-analogique) intégrés sur silicium de haute résolution, dont une des applications est les terminaux téléphoniques mobiles.
[1] D. Wouter J. Groeneveld et al, « A Self-Calibration Technique for Monolithic High-Resolution D/A Converters », Journal of Solid-State Circuits, vol.24, no 6, pp 1517-1522, décembre 1989.
[2] Mohammad Sarhang-Nejad, Gabor Temes, « A High-Resolution Multibit ΔΣ ADC with Digital Correction and Relaxed Amplifier Requirements », Journal of Solid-State Circuits, vol.28, no 6, pp 648-660, juin 1993.
3 T. Cataltepe et al, « Digitally corrected Multi-bit ΔΣ Data Converters », ISCAS'89, pp 647-650, 1989.

## Revendications

1. Modulateur ΔΣ comprenant des moyens (60,61,62) pour mesurer une erreur due à des écarts de paramètres de fonctionnement d'éléments unitaires de quantification de son convertisseur interne (50) N/A, et pour appliquer une correction de l'erreur ainsi mesurée sur un signal numérique (Ve,Vs), **caractérisé en ce que** le convertisseur interne (50) comprend un nombre d'éléments unitaires supérieur à celui nécessaire à la conversion interne, et que les moyens (60,61,62) sont en outre aptes à extraire alternativement du processus de conversion interne un élément unitaire à chaque fois différent parmi les différents éléments unitaires, tout en laissant actifs un nombre d'éléments unitaires suffisant à la conversion interne, afin ensuite de mesurer l'erreur de paramètre de fonctionnement de cet élément extrait.

2. Modulateur ΔΣ selon la revendication 1, **caractérisé en ce que** lesdits moyens comprennent un convertisseur ΔΣ A/N supplémentaire (60) et sont agencés pour commander une commutation apte à incorporer l'élément extrait dans le convertisseur ΔΣ supplémentaire (60) en tant que capacité d'échantillonage du modulateur ΔΣ de ce convertisseur ΔΣ supplémentaire.

3. Modulateur ΔΣ selon la revendication 2, **caractérisé en ce que** le convertisseur ΔΣ supplémentaire (60) est un convertisseur ΔΣ 1 bit d'ordre 1.

4. Modulateur ΔΣ selon la revendication 2, **caractérisé en ce que** le convertisseur ΔΣ supplémentaire (60) est un modulateur ΔΣ A/N suivi d'un moyen pour calculer une moyenne des valeurs de sortie du convertisseur ΔΣ supplémentaire (60).

5. Modulateur ΔΣ selon l'une quelconque des revendications précédentes, **caractérisé en ce que** le convertisseur N/A interne (50) dont on mesure les valeurs des éléments unitaires de quantification est un convertisseur à capacités commutées.

6. Modulateur ΔΣ selon la revendication précédente, **caractérisé en ce que** le convertisseur interne (50) dont on mesure les valeurs des éléments unitaires de quantification est intégré sur silicium.

## Patentansprüche

1. ΔΣ-Modulator, der Mittel (60, 61, 62) umfaßt, um einen Fehler zu messen, der von Abweichungen von Arbeitsparametern von Quantisierungs-Einheitselementen seines internen D/A-Wandlers (50) herrührt, und um eine Korrektur des so gemessenen Fehlers auf ein digitales Signal (Ve, Vs) anzuwenden, **dadurch gekennzeichnet, daß** der interne Wandler (50) eine Anzahl von Einheitselementen umfaßt, die größer ist als die zur internen Wandlung notwendige, und daß die Mittel (60, 61, 62) außerdem dafür eingerichtet sind, aus dem internen Wandlungsvorgang aus den verschiedenen Einheitselementen jedesmal ein anderes Einheitselement umschichtig herauszunehmen, wobei gleichzeitig für die interne Wandlung eine ausreichende Anzahl von Einheitselementen aktiv gelassen wird, um anschließend den Arbeitsparameterfehler dieses herausgenommenen Elements zu messen:

2. ΔΣ-Modulator nach Anspruch 1, **dadurch gekennzeichnet, daß** die Mittel einen zusätzlichen A/D ΔΣ-Wandler (60) umfassen und dafür ausgestaltet sind, eine Umschaltung zu steuern, die dafür geeignet ist, das herausgenommene Element in den zusätzlichen ΔΣ-Wandler (60) als Abtastkapazität des ΔΣ-Modulators dieses zusätzlichen ΔΣ-Wandlers aufzunehmen.

3. ΔΣ-Modulator nach Anspruch 2, **dadurch gekennzeichnet, daß** der zusätzlichen ΔΣ-Wandler (60) ein 1 Bit ΔΣ-Wandler 1. Ordnung ist.

4. ΔΣ-Modulator nach Anspruch 2, **dadurch gekennzeichnet, daß** der zusätzlichen ΔΣ-Wandler (60) ein A/D ΔΣ-Modulator ist, gefolgt von einem Mittel zur Berechnung eines Mittelwerts der Ausgangswerte des zusätzlichen ΔΣ-Wandlers (60).

5. ΔΣ-Modulator nach einem der vorhergehenden Ansprüche, **dadurch gekennzeichnet, daß** der interne D/A-Wandler (50), für den die Werte der Quantisierungs-Einheitselemente gemessen werden, ein Wandler mit geschalteten Kapazitäten ist.

6. ΔΣ-Modulator nach dem vorhergehenden Anspruch, **dadurch gekennzeichnet, daß** der interne Wandler (50), für den die Werte der Quantisierungs-Einheitselemente gemessen werden, in Silizium integriert ist.

## Claims

1. A ΔΣ modulator including means (60, 61, 62) for measuring an error due to differences in the operating parameters of individual quantizing elements of its internal D/A converter (50), and for applying a correction of the error measured in this way to a digital signal (Ve, Vs), the modulator being **characterized in that** the internal converter (50) comprises a number of individual elements greater than the number necessary for internal conversion, and **in that** the means (60, 61, 62) are also suitable for extracting individual elements in alternation from the internal conversion process, on each occasion extracting a different individual element from the various individual elements in order to measure subsequently the operating parameter error of the extracted element, while leaving a number of individual elements in action that is sufficient for internal conversion.

2. A ΔΣ modulator according to claim 1, **characterized in that** said means comprise an additional A/D ΔΣ converter (60) and are arranged to control switching suitable for incorporating the extracted element in the additional ΔΣ converter (60) as the sampling capacitor of the ΔΣ modulator of said additional ΔΣ converter.

3. A ΔΣ modulator according to claim 2, **characterized in that** the additional ΔΣ converter (60) is a first order 1-bit ΔΣ converter.

4. A ΔΣ modulator according to claim 2, **characterized in that** the additional ΔΣ converter (60) is an A/D ΔΣ modulator followed by means for computing an average of the output values from the additional ΔΣ converter (60).

5. A ΔΣ modulator according to any preceding claim, **characterized in that** the internal D/A converter (50) whose individual quantizing element values are measured is a switched capacitor converter.

6. A ΔΣ modulator according to the preceding claim, **characterized in that** the internal converter (50) whose quantizing element values are measured is integrated on silicon.
